# EUROPEAN PATENT APPLICATION

(11) **EP 3 647 995 A1**
(43) Date of publication of application: **06.05.2020**
(21) Application number: 18907464.4
(22) Date of filing: 21.09.2018
(51) Int. Cl.: G06K 9/00

(54) **FINGERPRINT IDENTIFICATION APPARATUS AND ELECTRONIC DEVICE**

(71) Applicant: Shenzhen Goodix Technology Co., Ltd., Shenzhen, Guangdong 518045 (CN)
(72) Inventor: ZENG, Lizhong, Shenzhen, Guangdong 518045 (CN); WU, Dan, Shenzhen, Guangdong 518045 (CN)
(74) Representative: Herrero & Asociados, S.L.
(86) International application number: PCT/CN2018/107115
(87) International publication number: WO 2020/056771

(57) **Abstract**

Embodiments of the present application disclose a fingerprint identification apparatus and an electronic device. The fingerprint identification apparatus is applied to an electronic device having a display screen, where the fingerprint identification apparatus includes an optical fingerprint sensor module configured to be disposed under the display screen so that a fingerprint capturing area of the optical fingerprint sensor module is at least partially located in a display area of the display screen, where the optical fingerprint sensor module includes a plurality of sensor chips, sensing areas of which correspond to a plurality of sub-areas in the fingerprint capturing area, respectively, and where each of the plurality of sensor chips is configured to detect an optical signal from above a sub-area corresponding to the each of the plurality of sensor chips. Technical solutions of embodiments of the present application could improve user experience in the process of fingerprint identification, and meanwhile, improve security of fingerprint identification.

## Description

### TECHNICAL FIELD

Embodiments of the present application relate to the technical field of fingerprint identification, and more particularly, to a fingerprint identification apparatus and an electronic device.

### BACKGROUND

With rapid development of mobile phone industry, fingerprint identification technology has received more and more attention from people, and practicality of under-screen fingerprint identification technology has become a popular requirement. Optical under-screen fingerprint identification technology refers that a fingerprint sensor captures reflected light formed by reflection of a finger from light emitted by a light source, where the reflected light carries fingerprint information of the finger, so as to implement under-screen fingerprint identification. When fingerprint identification is performed, a specific guide icon is displayed on a location of a display screen that corresponds to a location where a fingerprint sensor is placed, and a user needs to place a finger at the position where the guide icon is displayed for fingerprint identification, and as a result, user experience is not good.

### SUMMARY

Embodiments of the present application provide a fingerprint identification apparatus and an electronic device, which could improve user experience in the process of fingerprint identification, and meanwhile, improve security of fingerprint identification.

In a first aspect, there is provided a fingerprint identification apparatus, applied to an electronic device having a display screen, where the fingerprint identification apparatus includes an optical fingerprint sensor module configured to be disposed under the display screen so that a fingerprint capturing area of the optical fingerprint sensor module is at least partially located in a display area of the display screen, where the optical fingerprint sensor module includes a plurality of sensor chips, sensing areas of which correspond to a plurality of sub-areas in the fingerprint capturing area, respectively, and where each of the plurality of sensor chips is configured to detect an optical signal from above a sub-area corresponding to the each of the plurality of sensor chips.

In one possible implementation manner, when a to-be-detected finger is located on a part of the plurality of sub-areas, a sensor chip corresponding to the part of the plurality of sub-areas is in an operating state.

In one possible implementation manner, when a to-be-detected finger is located on a part of the plurality of sub-areas, the plurality of sensor chips are all in an operating state.

In one possible implementation manner, the plurality of sub-areas are distributed on both sides of the display screen, or the plurality of sub-areas are distributed on the same side of the display screen, or the plurality of sub-areas are distributed on a middle area of the display screen.

The plurality of sub-areas may be distributed at any discrete or continuous position of a display screen, and may even be customized according to needs of a customer to meet requirements of different electronic devices.

In one possible implementation manner, the plurality of sub-areas are the same in size, or not all of the plurality of sub-areas are completely the same in size.

In one possible implementation manner, the fingerprint identification apparatus further includes a plurality of optical path modulators which correspond to the plurality of sensor chips, respectively, where each of the plurality of optical path modulators is configured to direct an optical signal to an optical sensing array of a sensor chip corresponding to the each of the plurality of optical path modulators.

In one possible implementation manner, the fingerprint identification apparatus further includes at least one common optical path modulator, where each common optical path modulator corresponds to at least one sensor chip, and is configured to direct an optical signal to an optical sensing array of a sensor chip corresponding to the each common optical path modulator, respectively.

In one possible implementation manner, the optical path modulator includes at least one of an optical path collimator, a focus lens and a micro lens array.

In one possible implementation manner, the optical path modulator is encapsulated with a sensor chip corresponding to the optical path modulator; or the optical path modulator is mounted inside the fingerprint identification apparatus as a component that is relatively independent of the optical fingerprint sensor module.

In one possible implementation manner, the fingerprint identification apparatus further includes a plurality of filtering units which correspond to the plurality of sensor chips, respectively, wherein each of the plurality of filtering units is configured to select a wavelength of an optical signal transmitted to a sensor chip corresponding to the each of the plurality of filtering units.

In one possible implementation manner, the fingerprint identification apparatus further includes at least one common filtering unit, where each common filtering unit corresponds to at least one sensor chip, and is configured to select a wavelength of an optical signal transmitted to a sensor chip corresponding to the each common filtering unit.

In one possible implementation manner, the wavelength of the optical signal selected by the filtering unit includes a visible light wavelength or a near infrared light wavelength.

In one possible implementation manner, the filtering unit is encapsulated with a sensor chip corresponding to the filtering unit (for example, encapsulated with the sensor chip in a coating manner); or the filtering unit is encapsulated with an optical path modulator above a sensor chip corresponding to the filtering unit; or the filtering unit is encapsulated with a sensor chip and an optical path modulator corresponding to the filtering unit; or the filtering unit is mounted inside the fingerprint identification apparatus as a component that is relatively independent of the optical fingerprint sensor module and an optical path modulator.

In one possible implementation manner, the fingerprint identification apparatus further comprises a plurality of control units which correspond to the plurality of sensor chips, respectively, wherein each of the plurality of control units is configured to control an optical sensing array of a sensor chip corresponding to the each of the plurality of control units so as to detect an optical signal.

The control unit may further respond to a command of a main control unit of a device to which the fingerprint identification apparatus is applied and transmit data.

In one possible implementation manner, the fingerprint identification apparatus further includes a common control unit configured to control optical sensing arrays of the plurality of sensor chips so as to detect an optical signal.

The common control unit may further respond to a command of a main control unit of a device to which the fingerprint identification apparatus is applied and transmit data.

In one possible implementation manner, the fingerprint identification apparatus does not include a control unit, and a main control unit of a device to which the fingerprint identification apparatus is applied is configured to control optical sensing arrays of the plurality of sensor chips so as to detect an optical signal.

In one possible implementation manner, the fingerprint identification apparatus further includes a fixing unit connected between the display screen and the optical fingerprint sensor module, and configured to fix the optical fingerprint sensor module under the fingerprint capturing area in the display screen.

In one possible implementation manner, the fingerprint identification apparatus further includes a fixing unit, a middle frame is connected under the display screen, a light-leaking window is arranged at an area of the middle frame that corresponds to the fingerprint capturing area in the display screen, and the fixing unit is connected between the middle frame and the optical fingerprint sensor module, and configured to fix the optical fingerprint sensor module under the light-leaking window of the middle frame.

In a second aspect, there is provided an electronic device, including a display screen, and the fingerprint identification apparatus in the first aspect and any possible implementation manner of the first aspect.

In one possible implementation manner, the display screen is a liquid crystal display LCD screen.

In one possible implementation manner, the display screen is an organic light-emitting diode OLED display screen, a light-emitting layer of the display screen includes a plurality of organic light-emitting diode light sources, where the fingerprint identification apparatus adopts at least a part of the organic light-emitting diode light sources as an excitation source for fingerprint identification.

Based on the above technical solutions, since an optical fingerprint sensor module in the fingerprint identification apparatus includes a plurality of sensor chips, an area of a fingerprint capturing area in a display screen is increased, a to-be-detected finger of the user is allowed to have a larger moving range, and user experience in the fingerprint identification process is improved. Moreover, when a plurality of sensor chips are spliced together, fingerprint information on a larger area of a finger could be captured, or fingerprint information of more fingers could be captured at the same time, and correspondingly, the length of a fingerprint password is increased, and security of fingerprint identification is improved. In addition, since a user can provide more effective fingerprint features, false rejection rate (False Rejection Rate, FRR) and false acceptance rate (False Acceptance Rate, FAR) are also reduced, accuracy of fingerprint unlocking is improved, and user experience is further improved.

### BRIEF DESCRIPTION OF DRAWINGS

FIG. 1 is a schematic plan view of an electronic device to which the present application is applicable.
FIG. 2 is a partial schematic cross-sectional view of the electronic device shown in FIG 1 taken along A'-A'.
FIG. 3 is a schematic view of a fingerprint identification apparatus according to an embodiment of the present application.
FIG. 4 is a schematic structural view of a fingerprint identification apparatus according to another embodiment of the present application.
FIG. 5 is a schematic structural view of a fingerprint identification apparatus according to another embodiment of the present application.
FIG. 6 is a schematic view of a fingerprint capturing area according to an embodiment of the present application.
FIG. 7 is a schematic view of a fingerprint capturing area according to another embodiment of the present application.
FIGS. 8(a) and 8(b) are schematic views of a fingerprint capturing area according to another embodiment of the present application.
FIG. 9 is a schematic view of an optical path modulator according to an embodiment of the present application.
FIG. 10 is a schematic view of an optical path modulator according to another embodiment of the present application.
FIG. 11 is a schematic view of an optical path modulator according to another embodiment of the present application.
FIG. 12 is a schematic view showing that each sensor chip uses one optical path modulator separately according to another embodiment of the present application.
FIG. 13 is a schematic view showing that a plurality of sensor chips share one optical path modulator according to another embodiment of the present application.
FIG. 14 is a schematic view showing that each optical sensing array corresponds to one control unit according to an embodiment of the present application.
FIG. 15 is a schematic view showing that multiple optical sensing arrays correspond to one control unit according to another embodiment of the present application.

### DESCRIPTION OF EMBODIMENTS

The technical solutions in embodiments of the present application will be described hereinafter in conjunction with the accompanying drawings.

As an electronic device enters an era of full screen, a fingerprint capturing area on the front of the electronic device is squeezed by the full screen, and therefore, an under-display or under-screen fingerprint identification technology has gained an increasing attention. The under-screen fingerprint identification technology refers to mounting a fingerprint identification module (such as a fingerprint identification module) under a display screen, so as to realize a fingerprint identification operation in a display area of the display screen without setting a fingerprint capturing area in an area other than the display area on the front of an electronic device.

Optical under-screen fingerprint identification technology uses light returned from a top surface of a display component of a device for fingerprint sensing and other sensing operations. The returned light carries information of an object (e.g., a finger) in contact with the top surface, and is captured and detected to implement a particular optical sensor module under a display screen. The optical sensor module may be designed to achieve desired optical imaging by properly configuring optical elements for capturing and detecting the returned light.

It should be understood that technical solutions of embodiments of the present application can be applied to various electronic devices, for example, portable or mobile computing devices such as smart phones, notebook computers, tablet computers and game devices, and other electronic devices such as electronic databases, automobiles and automated teller machines (Automated Teller Machine, ATM), which is not limited in the embodiments of the present application.

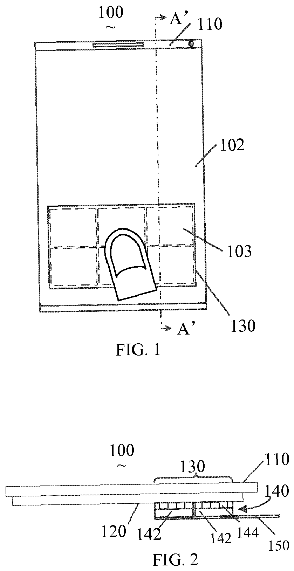

FIGS. 1 and 2 are schematic views showing an electronic device 100 to which a fingerprint identification apparatus is applicable. FIG. 1 is a schematic front view of an electronic device 100, and FIG. 2 is a partial schematic cross-sectional structural view of the electronic device 100 shown in FIG. 1 taken along A'-A'.

As shown in FIGS. 1 and 2, the electronic device 100 may include a display screen 120 and a fingerprint identification module 140; and the display screen 120 has a display area 102, and the fingerprint identification module 140 is disposed under the display screen 120.

The display screen 120 may be a self-emitting display screen that employs a self-emitting display unit as a display pixel. For example, the display screen 120 may be an organic light-emitting diode (Organic Light-Emitting Diode, OLED) display screen or a micro light-emitting diode (Micro-LED) display screen. In other alternative embodiments, the display screen 120 may also be a liquid crystal display (Liquid Crystal Display, LCD) screen or other passive light-emitting display screens, which is not limited in the embodiments of the present application.

On the other hand, the display screen 120 may be a touch display screen for example, which may not only perform image display, but also detect a touch or press operation of a user, thereby providing the user with a human-machine interaction interface. For example, in an embodiment, the electronic device 100 may include a touch sensor, and the touch sensor may be specifically a touch panel (Touch Panel, TP), which may be disposed on a surface of the display screen 120, or may be partially or wholly integrated into the display screen 120 to form the touch display screen.

The fingerprint identification module 140 may be specifically an optical fingerprint identification module, and is mainly used for capturing fingerprint information (such as fingerprint image information) of a user. In an embodiment of the present application, the fingerprint identification module 140 may be disposed at least in a partial area under the display screen 120 such that a fingerprint capturing area (or sensing area) 130 of the fingerprint identification module 140 is at least partially located in the display area 102 of the display screen 120. Here, an area of the fingerprint capturing area 130 may be different from that of the fingerprint identification module 140, for example, the area of the fingerprint capturing area 130 of the fingerprint identification module 140 may be allowed to be larger than that of the fingerprint identification module 140 by an optical path design such as lens imaging, reflective folding, or other light convergence or reflection. In other alternative implementation manners, if an optical path is directed by a light collimation method for example, the area of the fingerprint capturing area 130 of the fingerprint identification module 140 may also be designed to be consistent with that of the fingerprint identification module 140.

As an embodiment, the fingerprint identification module 140 may specifically include a plurality of optical fingerprint sensors 142 (hereinafter also referred to as sensor chips) having optical sensing arrays; and the plurality of optical fingerprint sensors 142 may be disposed side by side under the display screen 120. Each of the optical sensing arrays 142 includes multiple optical sensing units, respectively, and an area located by the optical sensing arrays correspond to a sensing area 103 of the optical fingerprint sensors in which the optical sensing arrays are located. The sensing area of the plurality of optical fingerprint sensors together constitutes the fingerprint capturing area 130 of the fingerprint identification module 140. That is, the fingerprint capturing area 130 of the fingerprint identification module 140 may include a plurality of sub-areas, each of which corresponds to the sensing area of one of the optical fingerprint sensors or the optical sensing arrays, respectively. As shown in FIG. 1, the fingerprint capturing area 130 is located in the display area 102 of the display screen 120. Since the plurality of optical fingerprint sensors are adopted to be disposed in the side by side manner, the fingerprint capturing area 130 of the fingerprint identification module 140 may be extended to a main area in the lower half part of the display area 102, that is, to a customary pressing area of a finger, thereby implementing a blind-press type fingerprint input operation. In other alternative embodiments, when the number of the optical fingerprint sensors is sufficient, the fingerprint capturing area 130 may be further extended to half or even the whole display area, thereby implementing half screen or full screen fingerprint detection. Therefore, when a user needs to unlock the electronic device 100 or perform other fingerprint verification, a fingerprint input operation can be implemented merely by pressing a finger on the fingerprint capturing area 130 in the display screen 120. Since fingerprint capturing and detection can be implemented inside the display area 102 of the display screen 120, a front face of the electronic device 100 in the above structure does not need to specially reserve space to set a fingerprint button (such as a Home button), so that it is possible that a full screen solution can be adopted. Therefore, the display area 102 of the display screen 120 could be substantially extended to the whole front face of the electronic device 100.

In a specific embodiment, the plurality of optical fingerprint sensors 142 of the fingerprint identification module 140 may be independently encapsulated sensor chips, or may be manufactured into multiple dies and encapsulated in the same chip encapsulant, or may further be manufactured in different areas of the same die by a semiconductor process. On the other hand, the optical fingerprint sensors 142 may also include a readout circuit and/or other auxiliary circuits that are electrically connected to the sensing arrays in addition to the optical sensing arrays as described above. As an optional implementation manner, as shown in FIG. 2, an optical path modulator 144 may further be disposed above the optical fingerprint sensor 142. Taking the optical path modulator 144 as an example, it may be attached to the sensing arrays of the optical fingerprint sensors 142 as an independent optical component, or integrated into the chip of the optical fingerprint sensors 142 by a semiconductor process, thereby implementing the ultra-thin fingerprint identification module 140. Specifically, the optical path modulator 144 may be an optical collimator having an array of through holes with a high aspect ratio, and is mainly used for collimating, modulating, and imaging downwardly propagating fingerprint detection light, so that reflected light from a finger surface is directed to the sensing arrays for optical detection to acquire fingerprint image information.

Optionally, the optical path modulator 144, which corresponds to the plurality of optical fingerprint sensors 142 of the fingerprint identification module 140, may be plural, and each optical path modulator 144 respectively corresponds to an optical fingerprint sensor, and is respectively attached to the corresponding optical fingerprint sensor 142. Alternatively, the plurality of optical fingerprint sensors 142 may also share one entire optical path modulator 144, that is, the optical path modulator 144 has an area large enough to cover the sensing arrays of the plurality of optical fingerprint sensors 142. In addition, other optical components may be further disposed between the optical path modulator 144 and the optical fingerprint sensor 142 or between the display screen 120 and the optical path modulator 144, for example, a filter or other optical films, which are mainly used to isolate the impact of external interference light on optical fingerprint detection. The filter may be used to filter out ambient light that penetrates a finger and enters into the image identification sensor 130 via the display screen 120. Similar to the optical path modulator 144, the filter may be respectively disposed on each of the optical fingerprint sensors 142 to filter out interference light, or a filter in a large area may also be used to cover the plurality of optical fingerprint sensors 142 simultaneously.

Alternatively, the optical path modulator 144 may also be replaced by an optical lens (lens), and pinholes may be formed by a light-shielding material above the optical lens to cooperate with the optical lens to converge fingerprint detection light to the optical fingerprint sensors 142 under the optical lens, thereby achieving fingerprint imaging. Similarly, each of the optical fingerprint sensors 142 may be respectively configured with an optical lens for fingerprint imaging, or the plurality of optical fingerprint sensors 142 may also utilize the same optical lens to achieve light convergence and fingerprint imaging. In other alternative embodiments, each of the optical fingerprint sensors 142 may even further have dual sensing arrays (Dual-Array) or multiple sensing arrays (Multi-Array), and two or more optical lenses are configured to cooperate with the dual or multiple sensing arrays for optical imaging so as to reduce imaging distance and enhance imaging effect.

In an embodiment of the present application, the display screen 120 adopting an OLED display screen is taken as an example, a light-emitting layer of the display screen 120 has OLED display unit arrays distributed in an array, and the fingerprint identification module 140 may utilize an OLED display unit (i.e., an OLED light source) of the OLED display screen 120 that is located in the fingerprint capturing area 130 as an excitation light source for fingerprint detection and identification. Of course, it should be understood that in other alternative implementations, the fingerprint identification module 140 may also provide an optical signal for fingerprint detection and identification by adopting a built-in light source or an external light source. In this case, an under-screen fingerprint identification apparatus can not only apply to a self-emitting display screen such as an OLED display screen, but also apply to a non-self-emitting display screen such as a liquid crystal display screen or other passive light-emitting display screens. For example, in the case of applying to a liquid crystal display screen having a backlight module and a liquid crystal panel, in order to support under-screen fingerprint detection of the liquid crystal display screen, the under-screen fingerprint identification apparatus may further include an excitation light source for optical fingerprint detection, and the excitation light source may be specifically an infrared light source or a light source at a specific invisible light wavelength. Taking the infrared light source as an example, it may be disposed under the backlight module of the liquid crystal display screen or disposed in an edge area under a protective cover of the electronic device 100, while the fingerprint identification module 140 is disposed under the backlight module, and the backlight module forms through holes or performs other optical designs on film layers such as diffusers, brightness enhancement sheets and reflectors to allow fingerprint detection light to pass through the liquid crystal panel and the backlight module and reach the optical fingerprint sensors of the fingerprint identification module 140.

Moreover, the optical sensing arrays of the fingerprint identification module 140 may be specifically a photo detector array (or referred to as a photodetector array) that includes multiple photo detectors distributed in an array, and the photo detectors may server as the optical sensing units as described above. A micro lens may be further formed above the photo detectors to improve an imaging effect of a fingerprint image.

When a finger touches, presses, or approaches (collectively referred to as pressing for convenience of description) the fingerprint capturing area 130, light emitted by the display unit of the fingerprint capturing area 130 or an additionally provided excitation source for fingerprint detection is reflected by the finger to form reflected light. The reflected light may carry fingerprint information of the finger of a user. For example, after the light is reflected by a fingerprint on the surface of the user's finger, the reflected light carries fingerprint information of the user, because the reflected light of a finger fingerprint ridge is different from that of a finger fingerprint valley. The reflected light is returned to the display screen 120, received by the photo detector array of the fingerprint identification module 140 under the display screen 120, and converted into a corresponding electrical signal, i.e., a fingerprint detection signal. The electronic device 100 can acquire fingerprint information of the user based on the fingerprint detection signal, and can further perform fingerprint matching verification, thereby completing identity verification of the current user so as to confirm whether the user has permission to perform a corresponding operation on the electronic device 100.

It should be understood that in a specific implementation, the electronic device 100 further includes a protective cover 110, the protective cover 110 may be specifically a transparent cover such as a glass cover or a sapphire cover which is located on the display screen 120 and covers a front face of the electronic device 100, and the surface of the protective cover 110 may also be provided with a protective layer. Therefore, in an embodiment of the present application, the so-called finger pressing the display screen 120 may actually refer to the finger pressing the cover 110 on the display screen 120 or covering a surface of the protective layer of the cover 110.

On the other hand, a circuit board 150 may further be provided under the fingerprint identification module 140, for example, a flexible printed circuit (flexible printed circuit, FPC). The fingerprint identification module 140 can be soldered to the circuit board 150 through a pad, and achieve electrical interconnection and signal transmission with other peripheral circuits or other elements of the electronic device 100 through the circuit board 150. For example, the fingerprint identification module 140 may receive a control signal of a processing unit of the electronic device 100 through the circuit board 150, and may also output the fingerprint detection signal to the processing unit, a control unit or the like of the electronic device 100 through the circuit board 150.

In some implementation manners of the fingerprint identification apparatus, a fingerprint identification module includes only one optical fingerprint sensor, so the fingerprint identification module has a small area and a fixed position. When fingerprint identification is required, a specific guide icon will be displayed at an area on a display screen corresponding to a position where the fingerprint identification module is placed, such as a fingerprint capturing area, for guiding a user to place a finger for fingerprint identification. This imposes a strict requirement on a position pressed by the user's finger, and requires a specific icon to be displayed in a fingerprint capturing area to guide the user to place the finger, and as a result, user experience is not good.

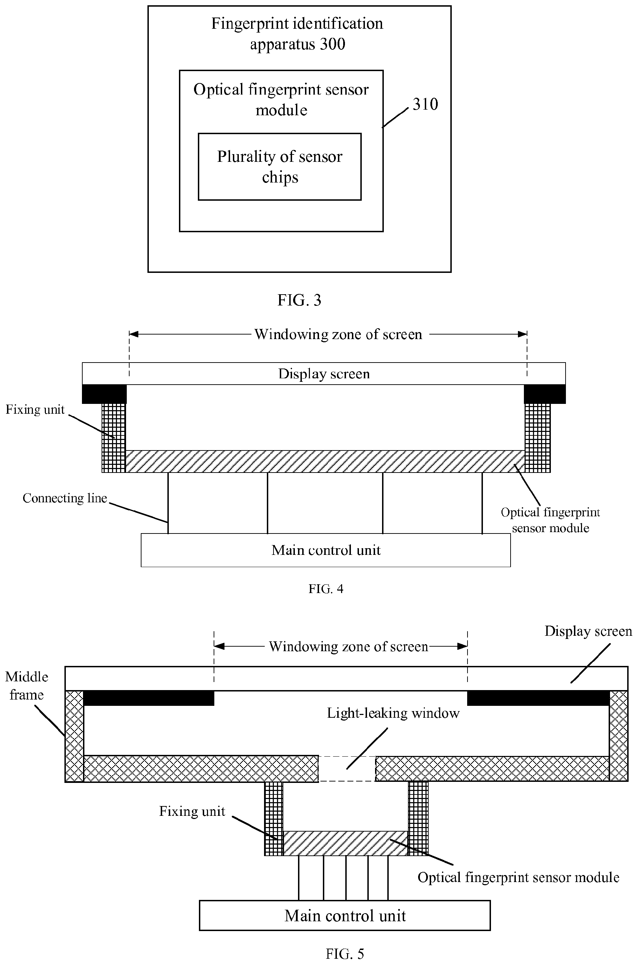

In view of the above, embodiments of the present application propose to adopt a solution of multiple sensors stitching shown in FIGS. 1 and 2 for under-screen fingerprint identification in order to improve user experience. The fingerprint identification apparatus of embodiments of the present application is described in detail below with reference to FIGS. 3 to 15.

FIG. 3 shows a schematic view of a fingerprint identification apparatus 300 according to an embodiment of the present application.

As shown in FIG. 3, the fingerprint identification apparatus 300 may be applied to an electronic device having a display screen, and the fingerprint identification apparatus 300 includes an optical fingerprint sensor module 310. The optical fingerprint sensor module 310 is configured to be disposed under the display screen so that a fingerprint capturing area of the optical fingerprint sensor module is at least partially located in a display area of the display screen, where the optical fingerprint sensor module 310 includes a plurality of sensor chips, sensing areas of which correspond to a plurality of sub-areas in the fingerprint capturing area, respectively, and where each of the plurality of sensor chips is configured to detect an optical signal from above a sub-area corresponding to the each of the plurality of sensor chips.

It should be understood that, in the embodiment of the present application, a sensing area of the sensor chips may be greater than or equal to an area physically occupied by the sensor chips. For example, based on the principle of optical imaging, each sensor chip may receive reflected light transmitted in an area greater than its physical area. At this time, the sensing area of the sensor chip is greater than its physically occupied area, the sensing area corresponds to a sub-area of the fingerprint capturing area, and an optical signal reflected by a to-be-detected finger to the sub-area can be captured by a sensor chip corresponding to the sub-area.

Optionally, the fingerprint identification apparatus further includes a fixing unit connected between the display screen and the optical fingerprint sensor module, and configured to fix the optical fingerprint sensor module under the fingerprint capturing area in the display screen.

For example, as shown in FIG. 4, a fixing unit is connected between an optical fingerprint sensor module and a display screen, and fixes the optical fingerprint sensor module under a fingerprint capturing area in a display screen. A plurality of sensor chips in the optical fingerprint sensor module correspond to a plurality of sub-areas of the fingerprint capturing area in the display screen, respectively, and an optical signal reflected by a finger in each sub-area is directly transmitted to a sensor chip corresponding to the each sub-area. When the plurality of sensor chips capture optical signals transmitted from the plurality of sub-areas respectively, the fingerprint identification apparatus may perform fingerprint identification for the finger on the fingerprint capturing area according to the optical signals transmitted from the plurality of sub-areas.

Optionally, the fingerprint identification apparatus further includes a fixing unit, a middle frame is connected under a display screen, a light-leaking window is arranged at an area of the middle frame that corresponds to a fingerprint capturing area in the display screen, and the fixing unit is connected between the middle frame and the optical fingerprint sensor module, and configured to fix the optical fingerprint sensor module under the light-leaking window of the middle frame.

For example, as shown in FIG. 5, a whole middle frame (a middle frame for short) is disposed under a display screen, and a light-leaking window is disposed at an area of the middle frame that corresponds to a fingerprint capturing area. The fixing unit is connected between an optical fingerprint sensor module and the middle frame, and fixes the optical fingerprint sensor module under the light-leaking window of the middle frame. A plurality of sensor chips in the optical fingerprint sensor module correspond to a plurality of sub-areas of the fingerprint capturing area in the display screen, respectively, and an optical signal reflected by a finger in each sub-area is transmitted to a sensor chip corresponding to the each sub-area through the light-leaking window. When the plurality of sensor chips capture optical signals transmitted from the plurality of sub-areas respectively, the fingerprint identification apparatus may perform fingerprint identification for a finger on the fingerprint capturing area according to the optical signals transmitted from the plurality of sub-areas.

It should be understood that the number of sensor chips included in the optical fingerprint sensor module is not limited in the embodiment of the present application, and the size and distribution position of the plurality of sensor chips are not limited. Adjacent optical fingerprint sensors allow a certain range of stitching gaps during stitching. The size, distribution and number of the plurality of optical fingerprint sensors can all be customized according to needs of a customer.

The size of the sensor chips may be determined by the size of optical sensing arrays (or referred to as light intensity sensing chips) included, and the optical sensing arrays include multiple sensing units (or referred to as photosensing pixels). The size of optical sensing arrays of different sensor chips in an optical fingerprint sensor module, or the number of photosensitive units, may be the same or different.

Optionally, the plurality of sub-areas corresponding to the plurality of sensor chips may be distributed on both sides of the display screen, or the plurality of sub-areas are distributed on the same side of the display screen, or the plurality of sub-areas are distributed in a middle area of the display screen.

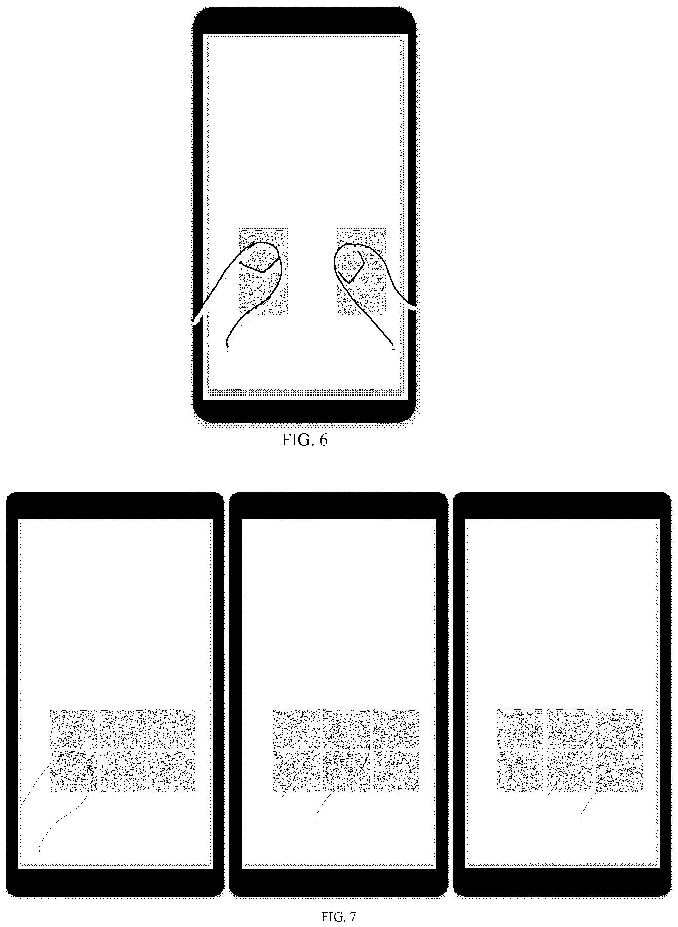

FIGS. 6 and 7 show two possible distribution of sensor chips. As shown in FIG. 6, a fingerprint capturing area in a display screen includes four sub-areas. Two sub-areas are located on the left side of the display screen so that a user can perform fingerprint detection of a left-hand finger, two sensor chips may be disposed under the two sub-areas, and the size of the two sensor chips may be the same or different. The remaining two sub-areas are located on the right side of the display screen so that a user can perform fingerprint detection of a right-hand finger, two sensor chips may be disposed under the two sub-areas, and the size of the two sensor chips may be the same or different. When a user accesses a device, a left-hand finger can be placed in the two sub-areas on the left side for fingerprint identification, or a right-hand finger can be placed in the two sub-areas on the right side for fingerprint identification, or the left-hand and right-hand fingers can be respectively placed in the sub-areas on both sides at the same time to improve security of fingerprint identification.

For another example, as shown in FIG. 7, a fingerprint capturing area in a display screen includes six sub-areas. These six sub-areas are located in the middle of the display screen, thereby forming a large area of fingerprint capturing area. A finger may move freely in the large area of fingerprint capturing area, and finger information can be captured regardless of a position where the finger is placed in the fingerprint capturing area. Six corresponding sensor chips may be disposed under the six sub-areas, and the size of the six sensor chips may be the same or different.

The areas of the sub-areas shown in FIGS. 6 and 7 are equal, however, the present application is not limited thereto, and the plurality of sub-areas may also be different in area, or may further have different shapes.

Compared with a case where there is only one sensor chip under a display screen, and a user needs to place a finger on a specific area corresponding to the sensor chip for fingerprint identification, distribution of a plurality of sensor chips under a display screen could expand a moving range of a user's finger and enhance user experience in the process of fingerprint identification. Moreover, when a plurality of sensor chips are spliced together, fingerprint information on a larger area of a finger could be captured, and correspondingly, the length of a fingerprint password is increased, and security of fingerprint identification is improved.

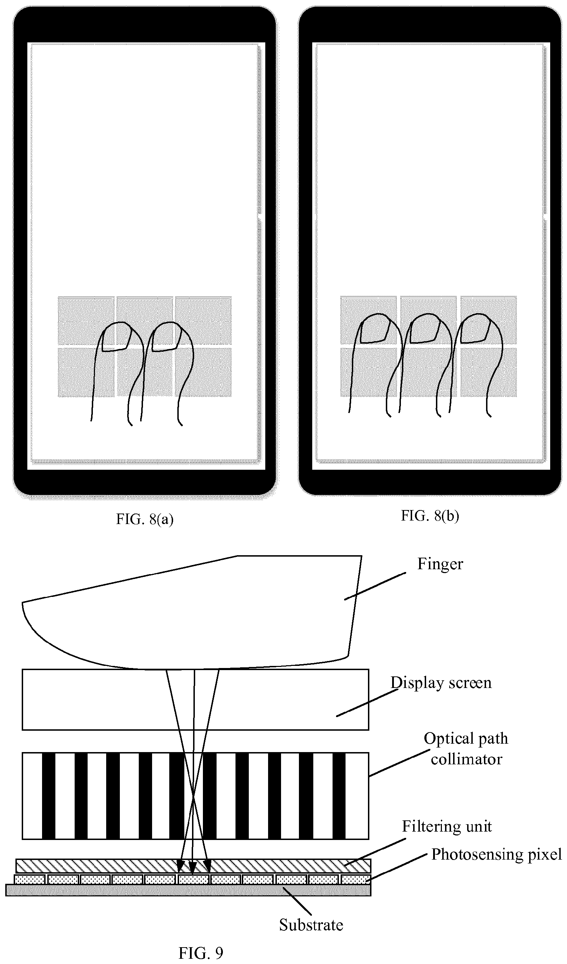

In addition, the distribution of the plurality of sensor chips under the display screen could expand the area of the fingerprint capturing area, so that fingerprint information of more fingers could be captured at the same time. A user can place several fingers at the same time for fingerprint identification to improve security of fingerprint identification. For example, as shown in FIG. 8(a), assuming that an access to a terminal device or a specific application is set to identify fingerprints of two fingers at the same time, a user can place two to-be-detected fingers in a large area of fingerprint capturing area shown in FIG. 8(a), so that fingerprint information of the two fingers is captured by sensor chips under the fingerprint capturing area, and more fingerprint information is acquired. For example, as shown in FIG. 8(b), assuming that an access to a terminal device or an application is set to identify fingerprints of three fingers at the same time, a user can place three to-be-detected fingers in a large area of fingerprint capturing area shown in FIG. 8(b), so that fingerprint information of the three fingers is captured by sensor chips under the fingerprint capturing area, and more fingerprint information is acquired.

Since a user can provide more effective fingerprint features, FRR and FAR are reduced, accuracy of fingerprint unlocking is improved, and user experience is further improved.

It should be understood that, in addition to the cases shown in FIGS. 6 to 8, the plurality of sub-areas may be distributed in any discrete or continuous position of a display screen, and may even be customized according to needs of a customer so as to meet the needs of different electronic devices.

In an embodiment of the present application, when a to-be-detected finger is located on a part of the plurality of sub-areas of a fingerprint capturing area, a sensor chip corresponding to the part of the plurality of sub-areas is in an operating state. That is, the fingerprint identification apparatus could determine sensor chips that need to perform fingerprint image capturing according to a position pressed by a user's finger, and the sensor chips that need to perform fingerprint image capturing enter an operating state to capture an optical signal, while the remaining sensor chips can be in a sleep state, thereby reducing power consumption effectively.

For example, in FIG. 6, when a finger press is detected on two sub-areas on the left side of a display screen, sensor chips corresponding to the two sub-areas on the left side enter an operating state, and an optical signal reflected by the finger is captured for fingerprint identification, while sensor chips corresponding to two sub-areas on the right side can be in a sleep state to save power consumption. However, when a finger press is detected on the two sub-areas on the right side of a display screen, sensor chips corresponding to the two sub-areas on the right side enter an operating state, and an optical signal reflected by the finger is captured for fingerprint identification, while sensor chips corresponding to the two sub-areas on the left side can be in a sleep state to save power consumption.

Of course, in order to simplify the process of fingerprint identification, when a user's finger is detected to press a part of the sub-areas of the fingerprint capturing area, the plurality of sensor chips may also be controlled to enter an operating state at the same time. This is not limited in the embodiment of the present application.

Optionally, the fingerprint identification apparatus further includes a plurality of optical path modulators (or referred to as an optical path conditioning unit and the like) which correspond to the plurality of sensor chips, respectively, where each of the plurality of optical path modulators is configured to direct an optical signal to an optical sensing array (or referred to as a light intensity sensing chip, a sensing chip, etc.) of a sensor chip corresponding to the each of the plurality of optical path modulators.

Alternatively, optionally, the fingerprint identification apparatus further includes at least one common optical path modulator, where each common optical path modulator corresponds to at least one sensor chip, and is configured to direct an optical signal to an optical sensing array of a sensor chip corresponding to the each common optical path modulator, respectively.

For example, a common optical path modulator may be disposed above the six sensor chips corresponding to the six sub-areas shown in FIG. 7, and the common optical path modulator is configured to direct an optical signal to optical sensing arrays of the six sensor chips, respectively.

For another example, six optical path modulators may be disposed above the six sensor chips corresponding to the six sub-areas shown in FIG. 7, respectively, and each of the optical path modulators is configured to direct an optical signal to an optical sensing array of a sensor chip corresponding to the each of the optical path modulators, respectively.

For another example, in the four sensor chips corresponding to the four sub-areas shown in FIG. 6, one optical path modulator may be disposed above the sensor chips corresponding to the sub-areas on the left side, and another light path modulator may be disposed above the sensor chips corresponding to the sub-areas on the right side.

The optical path modulator may be further used to filter out stray light to obtain an effective optical signal or the like.

The optical path modulator may include an optical path collimator, a focus lens, a micro lens array, an optical fiber array (core or coreless), and the like for example. A plurality of sensor chips in an optical fingerprint sensor module may be used with different types of optical path modulators, or the same type of optical path modulator.

Optionally, the optical path modulator is encapsulated with a sensor chip corresponding to the optical path modulator; or the optical path modulator is mounted inside the fingerprint identification apparatus as a component that is relatively independent of the optical fingerprint sensor module.

For example, as shown in FIG. 9, the optical path modulator may be specifically an optical path collimator made of a semiconductor silicon wafer or a silicon oxide or a nitride, and has a plurality of collimating units which may be used as modulating units of the optical path modulator. Specifically, the modulating units may be through holes with a high aspect ratio, and thus the plurality of collimating units may constitute an array of through holes of the optical path modulator. In reflected light from a finger, light incident on the modulating units may pass through and be received by optical sensing units under the modulating units, and each of the optical sensing units may substantially receive the reflected light of texture of fingerprint directed by the through hole above the each of the optical sensing units, so that optical sensing arrays could detect a fingerprint image of the finger.

When the optical path modulator uses the optical path collimator shown in FIG. 9 for example, optionally, each of the modulating units of the optical path modulator may correspond to an optical sensing unit (or referred to as a photosensing pixel) of the optical sensing arrays. Alternatively, the modulating units may not be in one-to-one correspondence with the optical sensing units of the sensing arrays to reduce moire interference. For example, an optical sensing unit may correspond to multiple modulating units, or the modulating units may also be arranged in an irregular manner to achieve unspecific correspondence with the optical sensing units of the sensing arrays. When the modulating units of the optical path modulator are arranged in an irregular manner, the optical fingerprint apparatus may correct reflected light detected by each of sensing units by a post-software algorithm.

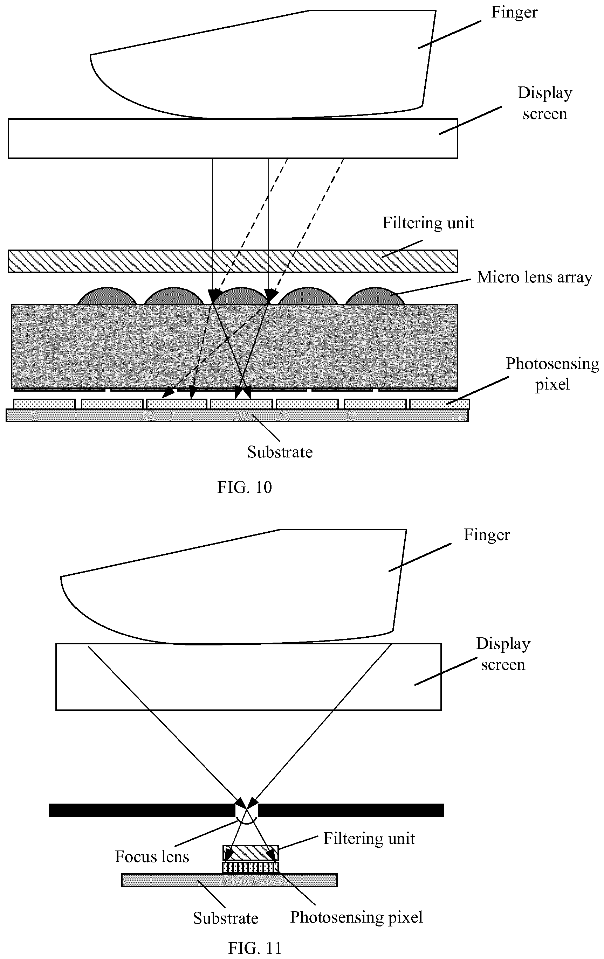

For another example, as shown in FIG. 10, the optical path modulator may be specifically a micro lens array made of a semiconductor silicon wafer or a silicon oxide or a nitride, and has a plurality of micro lenses which may be used as modulating units of the optical path modulator. In reflected light from a finger, light incident on the modulating units may pass through and be received by optical sensing units under the modulating units, and each of the optical sensing units may substantially receive the reflected light of texture of fingerprint directed by a through hole above the each of the optical sensing units, so that optical sensing arrays could detect a fingerprint image of the finger.

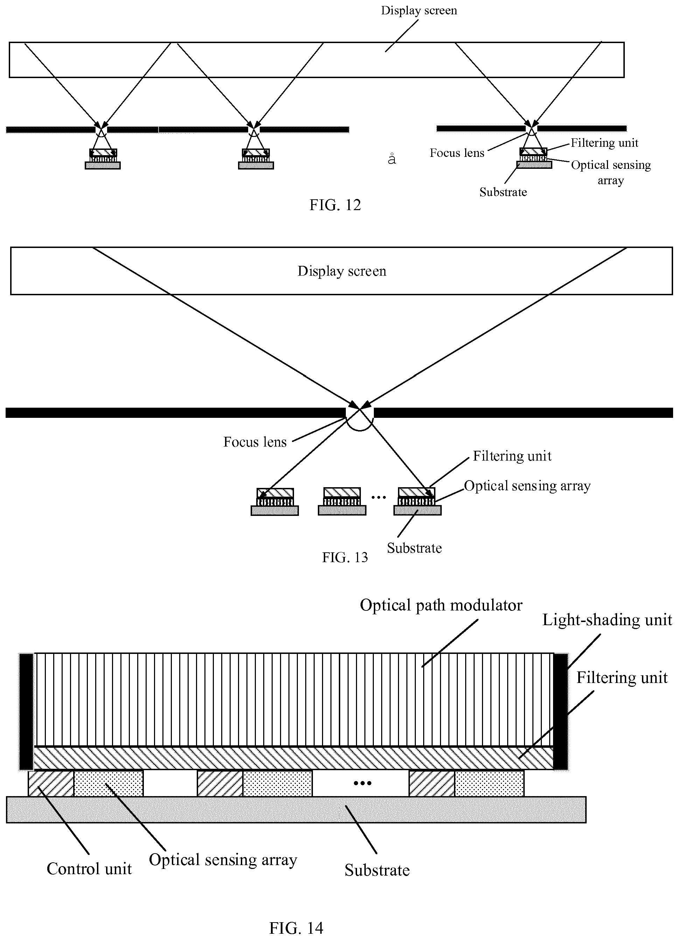

For another example, as shown in FIG. 11, the optical path modulator may be specifically a focus lens. The focus lens may direct an optical signal reflected by a finger on a fingerprint capturing area to an optical sensing array. A focus lens may be disposed above an optical sensing array of each sensor chip, and the focus lens is configured to direct an optical signal to a corresponding optical sensing array under the focus lens. For example, as shown in FIG. 12, each of optical sensing arrays uses a focus lens corresponding to the respective optical sensing array, respectively. Therefore, a plurality of sensor chips may use a plurality of optical path modulators. Alternatively, a plurality of sensor chips may share the same optical path modulator. For example, as shown in FIG. 13, multiple optical sensing arrays share the same focus lens, and the focus lens is configured to direct an optical signal to multiple optical sensing arrays, respectively.

Optionally, when the optical path modulator is an optical path collimator or a micro lens array, the optical fingerprint sensor module may be mounted on a side of a display screen in a fixed manner as shown in FIG. 4, and when the optical path modulator is a focus lens, the optical fingerprint sensor module may be mounted on a side of a whole middle frame in a fixed manner as shown in FIG. 5.

Optionally, the fingerprint identification apparatus further includes a plurality of filtering units which correspond to the plurality of sensor chips, respectively, where each of the plurality of filtering units is configured to select a wavelength of an optical signal transmitted to a sensor chip corresponding to the each of the plurality of filtering units.

Alternatively, optionally, the fingerprint identification apparatus further includes at least one common filtering unit, where each common filtering unit corresponds to at least one sensor chip, and is configured to select a wavelength of an optical signal transmitted to a sensor chip corresponding to the each common filtering unit.

When the fingerprint identification apparatus includes only one common filtering unit, the filtering unit is located above the optical fingerprint identification module to select a wavelength of an optical signal transmitted to the optical fingerprint identification module.

The wavelength of the optical signal selected by the filtering unit may be, for example, a visible light wavelength (370 nm to 780 nm) or a near infrared light wavelength (800 nm to 1500 nm). An optical signal at a wavelength beyond the wavelength corresponding to the filtering unit will not pass through the filtering unit to reach an optical sensing array of an optical fingerprint sensor.

Optionally, the filtering unit is encapsulated with a sensor chip corresponding to the filtering unit (for example, encapsulated with the sensor chip in a coating manner); or the filtering unit is encapsulated with an optical path modulator above a sensor chip corresponding to the filtering unit; or the filtering unit is encapsulated with a sensor chip and an optical path modulator corresponding to the filtering unit; or the filtering unit is mounted inside the fingerprint identification apparatus as a component that is relatively independent of the optical fingerprint sensor module and an optical path modulator.

Light emitted by a light source (such as a display screen and the like) is reflected on a surface of a to-be-detected finger on the display screen, and the light path modulator modulates the reflected light from the surface of the finger and directs the reflected light to a filtering unit. The reflected light is filtered by the filtering unit and then received by an optical fingerprint sensor module, and the optical fingerprint sensor module may further detect the received reflected light to implement fingerprint identification. It should be understood that the foregoing optical fingerprint apparatus is merely an exemplary structure. In a specific implementation, the position of the filtering unit is not limited to being under the optical path modulator; for example, in an alternative embodiment, the filtering unit may also be disposed between the optical path modulator and the display screen, i.e., being above the optical path modulator; or the optical components may include two layers of filtering units, which are respectively disposed above and under the optical path modulator. In other alternative embodiments, the filtering unit may also be integrated into the optical path modulator, and may even be omitted, which is not limited in the embodiments of the present application.

Optionally, the fingerprint identification apparatus further includes a plurality of control units which correspond to the plurality of sensor chips, respectively, where each of the plurality of control units is configured to control an optical sensing array of a sensor chip corresponding to the each of the plurality of control units so as to detect an optical signal.

The control unit may further respond to a command of a main control unit of a device to which the fingerprint identification apparatus is applied and transmit data.

For example, as shown in FIG. 14, an optical sensing array of each sensor chip is controlled by a control unit, and the control unit may control a corresponding optical sensing array through instructions to perform a corresponding operation, for example, inputting a driving signal to the optical sensing array and receiving a sensing signal output by the optical sensing array, and determining fingerprint information according to the received sensing signal.

Alternatively, optionally, the optical fingerprint sensor module further includes a common control unit configured to control optical sensing arrays of the plurality of sensor chips so as to detect an optical signal.

The common control unit may further respond to a command of a main control unit of a device to which the fingerprint identification apparatus is applied and transmit data.

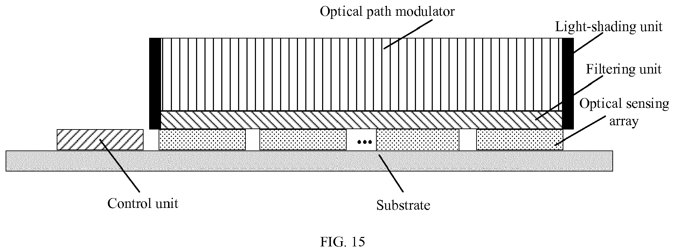

For example, as shown in FIG. 15, all optical sensing arrays of the plurality of sensor chips are controlled by the same control unit, and the control unit may control the plurality of optical sensing arrays through instructions to perform a corresponding operation, such as inputting a driving signal to some or all of the optical sensing arrays and receiving sensing signals output by the optical sensing arrays, and determining fingerprint information according to the received sensing signals.

Alternatively, optionally, a part of the optical sensing array share a control unit. For example, in FIG. 6, the corresponding sensor chip under the sub-area on the left side is controlled by one control unit, and the corresponding sensor chip under the sub-area on the right side is controlled by another control unit.

Alternatively, optionally, the fingerprint identification apparatus does not include a control unit, and a main control unit of a device (such as a terminal device and the like) to which the fingerprint identification apparatus is applied is configured to control optical sensing arrays of the plurality of sensor chips so as to detect an optical signal.

The optical sensing arrays of the plurality of sensor chips may be encapsulated together, or may be independently encapsulated and then connected together, which is not limited herein.

Furthermore, the optical fingerprint sensor module may further include a light-shading device to prevent stray light from entering the optical fingerprint sensor module.

It should be understood that a fingerprint identification apparatus of an embodiment of the present application may perform fingerprint identification based on a plurality of sensor chips to determine whether the detected fingerprint information is fingerprint information of an authorized user. Also, optionally, the plurality of sensor chips may further detect biometric characteristics of the finger to determine whether the finger is a living finger or a fake fingerprint, or detect a touching force of the finger. For example, information such as a glucose level or a degree of oxygen saturation may be measured based on optical light reflected by the finger, so as to determine whether the finger is a living finger or a fake fingerprint. As yet another example, a touching force of a finger press may be determined based on detected fingerprint pattern deforming, a change in the contacting area between the finger and a screen surface, fingerprint ridge widening, or a blood flow dynamics change.

It should be understood that parts of the same pattern filled in FIGS. 1 to 15 are shown to have the same function.

It should further be understood that embodiments of the present application do not limit connection manners between various components in the fingerprint identification apparatus 300.

An embodiment of the present application further provides an electronic device, and the electronic device may include a display screen and the fingerprint identification apparatus in the above various embodiments of the present application.

The electronic device may be any electronic device having a display screen, which implements under-screen fingerprint identification using a technical solution of an embodiment of the present application.

The display screen may be the display screen described above, such as an LCD screen or an OLED display screen.

When the display screen is an organic light-emitting diode display screen, a light-emitting layer of the display screen includes a plurality of organic light-emitting diode light sources, where the fingerprint identification apparatus adopts at least a part of the organic light-emitting diode light sources as an excitation source for fingerprint identification.

It should be appreciated that specific examples in embodiments of the present application are just for helping those skilled in the art better understand the embodiments of the present application, rather than for limiting the scope of the present application.

It should also be appreciated that terms used in embodiments of the present application and the claims appended hereto are merely for the purpose of describing particular embodiments, and are not intended to limit the embodiments of the present application. For example, the use of a singular form of "a", "the above" and "the" in the embodiments of the present application and the claims appended hereto are also intended to include a plural form, unless otherwise clearly indicated herein by context.

Those of ordinary skill in the art may be aware that, units of the examples described in the embodiments disclosed in this paper may be implemented by electronic hardware, computer software, or a combination of the two. To clearly illustrate interchangeability between the hardware and the software, the foregoing illustration has generally described composition and steps of the examples according to functions. Whether these functions are executed in hardware or software mode depends on a particular application and a design constraint condition of the technical solutions. Persons skilled in the art may use different methods to implement the described functions for every particular application, but it should not be considered that such implementation goes beyond the scope of the present application.

In the several embodiments provided in the present application, it should be understood that, the disclosed system and apparatus may be implemented in other manners. For example, the foregoing described apparatus embodiments are merely exemplary. For example, division of the units is merely logical function division and there may be other division manners in practical implementation. For example, multiple units or components may be combined or integrated into another system, or some features may be ignored or not executed. In addition, the displayed or discussed mutual coupling or direct coupling or communication connection may be indirect coupling or communication connection through some interfaces, apparatuses or units, and may also be electrical, mechanical, or connection in other forms.

The units described as separate parts may or may not be physically separate, and parts displayed as units may or may not be physical units, may be located in one position, or may be distributed on multiple network units. Part of or all of the units here may be selected according to a practical need to achieve the objectives of the solutions of the embodiments of the present application.

In addition, various functional units in the embodiments of the present application may be integrated into a processing unit, or each unit may exist alone physically, or two or more than two units may be integrated into one unit. The integrated unit may be implemented in a form of hardware, or may be implemented in a form of a software functional unit.

If being implemented in the form of a software functional unit and sold or used as a separate product, the integrated unit may be stored in a computer-readable storage medium. Based on such understanding, the nature of the technical solutions of the present application, or the part contributing to the prior art, or all of or part of the technical solutions may be implemented in a form of software product. The computer software product is stored in a storage medium and includes several instructions for instructing a computer device (which may be a personal computer, a server, or a network device, and the like) to execute all of or part of the steps of the method described in the embodiments of the present application. The foregoing storage medium includes: various media that may store program codes, such as a U-disk, a removable hard disk, a read-only memory (ROM, Read-Only Memory), a random access memory (RAM, Random Access Memory), a magnetic disk, a compact disk, and so on.

The foregoing description is only a specific implementation manner of the present application. The protection scope of the present application, however, is not limited here. Various modifications or replacements may be readily conceivable to any person skilled in the art within the technical scope disclosed in the present application, and such modifications or replacements shall fall within the protection scope of the present application. Therefore, the protection scope of the present application shall be subject to the protection scope of the claims.

## Claims

1. A fingerprint identification apparatus, applied to an electronic device having a display screen, wherein the fingerprint identification apparatus comprises an optical fingerprint sensor module configured to be disposed under the display screen so that a fingerprint capturing area of the optical fingerprint sensor module is at least partially located in a display area of the display screen, wherein the optical fingerprint sensor module comprises a plurality of sensor chips, sensing areas of which correspond to a plurality of sub-areas in the fingerprint capturing area, respectively, and wherein each of the plurality of sensor chips is configured to detect an optical signal from above a sub-area corresponding to the each of the plurality of sensor chips.

2. The fingerprint identification apparatus according to claim 1, wherein when a to-be-detected finger is located on a part of the plurality of sub-areas, a sensor chip corresponding to the part of the plurality of sub-areas is in an operating state.

3. The fingerprint identification apparatus according to claim 1, wherein when a to-be-detected finger is located on a part of the plurality of sub-areas, the plurality of sensor chips are all in an operating state.

4. The fingerprint identification apparatus according to any of claims 1 to 3, wherein the plurality of sub-areas are distributed on both sides of a display screen, or the plurality of sub-areas are distributed on the same side of the display screen, or the plurality of sub-areas are distributed on a middle area of the display screen.

5. The fingerprint identification apparatus according to any of claims 1 to 4, wherein the plurality of sub-areas are the same in size, or not all of the plurality of sub-areas are completely the same in size.

6. The fingerprint identification apparatus according to any of claims 1 to 5, wherein the fingerprint identification apparatus further comprises a plurality of optical path modulators which correspond to the plurality of sensor chips, respectively, wherein each of the plurality of optical path modulators is configured to direct an optical signal to an optical sensing array of a sensor chip corresponding to the each of the plurality of optical path modulators.

7. The fingerprint identification apparatus according to any of claims 1 to 5, wherein the fingerprint identification apparatus further comprises at least one common optical path modulator, wherein each common optical path modulator corresponds to at least one sensor chip, and is configured to direct an optical signal to an optical sensing array of a sensor chip corresponding to the each common optical path modulator, respectively.

8. The fingerprint identification apparatus according to claims 6 or 7, wherein the optical path modulator comprises at least one of an optical path collimator, a focus lens and a micro lens array.

9. The fingerprint identification apparatus according to any of claims 6 to 8, wherein the optical path modulator is encapsulated with a sensor chip corresponding to the optical path modulator; or
the optical path modulator is mounted inside the fingerprint identification apparatus as a component that is relatively independent of the optical fingerprint sensor module.

10. The fingerprint identification apparatus according to any of claims 1 to 9, wherein the fingerprint identification apparatus further comprises a plurality of filtering units which correspond to the plurality of sensor chips, respectively, wherein each of the plurality of filtering units is configured to select a wavelength of an optical signal transmitted to a sensor chip corresponding to the each of the plurality of filtering units.

11. The fingerprint identification apparatus according to any of claims 1 to 9, wherein the fingerprint identification apparatus further comprises at least one common filtering unit, wherein each common filtering unit corresponds to at least one sensor chip, and is configured to select a wavelength of an optical signal transmitted to a sensor chip corresponding to the each common filtering unit.

12. The fingerprint identification apparatus according to claims 10 or 11, wherein the wavelength of the optical signal selected by the filtering unit comprises a visible light wavelength or a near infrared light wavelength.

13. The fingerprint identification apparatus according to any of claims 10 to 12, wherein
the filtering unit is encapsulated with a sensor chip corresponding to the filtering unit; or
the filtering unit is encapsulated with an optical path modulator above a sensor chip corresponding to the filtering unit; or
the filtering unit is encapsulated with a sensor chip and an optical path modulator corresponding to the filtering unit; or
the filtering unit is mounted inside the fingerprint identification apparatus as a component that is relatively independent of the optical fingerprint sensor module and an optical path modulator.

14. The fingerprint identification apparatus according to any of claims 1 to 13, wherein the fingerprint identification apparatus further comprises a plurality of control units which correspond to the plurality of sensor chips, respectively, wherein each of the plurality of control units is configured to control an optical sensing array of a sensor chip corresponding to the each of the plurality of control units so as to detect an optical signal.

15. The fingerprint identification apparatus according to any of claims 1 to 14, wherein the fingerprint identification apparatus further comprises a common control unit configured to control optical sensing arrays of the plurality of sensor chips so as to detect an optical signal.

16. The fingerprint identification apparatus according to any of claims 1 to 14, wherein the fingerprint identification apparatus does not comprise a control unit, and a main control unit of a device to which the fingerprint identification apparatus is applied is configured to control optical sensing arrays of the plurality of sensor chips so as to detect an optical signal.

17. The fingerprint identification apparatus according to any of claims 1 to 16, wherein the fingerprint identification apparatus further comprises a fixing unit connected between a display screen and the optical fingerprint sensor module, and configured to fix the optical fingerprint sensor module under the fingerprint capturing area in the display screen.

18. The fingerprint identification apparatus according to any of claims 1 to 16, wherein the fingerprint identification apparatus further comprises a fixing unit, a middle frame is connected under a display screen, a light-leaking window is arranged at an area of the middle frame that corresponds to the fingerprint capturing area in the display screen, and the fixing unit is connected between the middle frame and the optical fingerprint sensor module, and configured to fix the optical fingerprint sensor module under the light-leaking window of the middle frame.

19. An electronic device, comprising:
a display screen, and
the fingerprint identification apparatus according to any of claims 1 to 18.

20. The electronic device according to claim 19, wherein the display screen is a liquid crystal display, LCD, screen.

21. The electronic device according to claim 19, wherein the display screen is an organic light-emitting diode, OLED, display screen, and a light-emitting layer of the display screen comprises a plurality of organic light-emitting diode light sources, wherein the fingerprint identification apparatus employs at least a part of the organic light-emitting diode light sources as excitation light sources for fingerprint identification.
